# EUROPÄISCHE PATENTSCHRIFT

(11) **EP 0 769 814 B1**
(45) Veröffentlichungstag und Bekanntmachung des Hinweises auf die Patenterteilung: **31.07.2002**
(21) Anmeldenummer: 96115763.3
(22) Anmeldetag: 02.10.1996
(51) Int. Cl.: H01L 21/78, H01L 21/00

(54) **Verfahren zum Trennen von in einem Körper verbundenen Elementen, insbesondere elektronischen Elementen**
Method for separating devices on a common substrate, in particular electronic device elements
Méthode pour séparer des éléments assemblés dans un corps, notamment des éléments électroniques

(30) Priorität: 17.10.1995 DE 19538634
(43) Veröffentlichungstag der Anmeldung: 23.04.1997
(73) Patentinhaber: Micronas GmbH, 79108 Freiburg (DE)
(72) Erfinder: Igel, Günter, Dipl.-Ing., 79331 Teningen (DE); Mall, Martin, Dr.rer.nat.Dipl.-Phys., 79100 Freiburg (DE)

(56) Entgegenhaltungen:
- US-A- 4 236 296
- US-A- 4 418 472
- US-A- 5 196 378
- US-A- 5 418 190
- MOTOROLA TECHNICAL DEVELOPMENTS, Bd. 23, Oktober 1994, Seite 8 XP000468360 SHUMATE D ET AL: "SILICON WAFER THINNING AND DICING ROUND OR NON ORTHOGENAL DIE USING DRY ETCHING"

## Beschreibung

Die Erfindung betrifft ein Verfahren zum Trennen von in einem Körper verbundenen Elementen mit den Merkmalen des Oberbegriffs des Patentanpruchs 1.

Ein solches Verfahren ist aus Motrola Technical Developments, Bb 23, Oktober 1994, Seite 8, XP000468360 Shumak D Et Al, bekannt.

Für ein solches Verfahren kommen Elemente in Betracht, die in einem Körper verbunden sind und voneinander getrennt werden sollen. Ein großes Einsatzgebiet des Verfahrens ist die Halbleitertechnik, in der elektronische Elemente in einem Halbleiterwafer miteinander verbunden sind und voneinander getrennt werden sollen. Weitere Anwendungsmöglichkeiten sind das Herausteilen von Einzelelementen in Verbundleiterplatten, das Trennen von Keramikleiterplatten, Sensoren und Mikromaschinen.

Aus US-A-5196378 ist ein Verfahren zum Trennen von elektronischen Elementen aus einem Halbleiterwafer bekannt. Hierzu wird der Wafer durch eine Öffnung in der Maske anisotrop durch die aktive Schicht hindurch und in das Substrat hinein geätzt, so daß auf Grund der Kristallorientierung ein V-förmiger Kanal entsteht. Dann wird in den Wafer von der Rückseite ein weiterer V-förmiger Kanal geätzt, wobei dieser Kanal dem Anderen gegenüber liegt. Die Tiefe des zweiten Kanals wird so gewählt, daß die elektronischen Elemente beim Aufeinandertreffen der gegenüberliegenden Kanäle voneinander getrennt werden.

Die US-A-4418472 offenbart ein Verfahren zum Trennen von elektronischen Elementen in einem Halbleiterwafer. Hierzu werden Vertiefungen durch einen mechanischen Materialabtrag, wie Fräsen, in die Oberfläche des Substrats eingebracht. Danach werden die verschiedenen Elemente durch anisotropes Ätzen voneinander getrennt.

Aus der DE 40 20 195 ist ein Verfahren zum Trennen von elektronischen Elementen aus einem Halbleiterwafer bekannt. Das Trennen der elektronischen Elemente erfolgt durch Sägen entlang von Sägelinien. Ein derartiges Verfahren hat z. B. den Nachteil, daß durch den Sägevorgang Risse entstehen, die sich in den aktiven Bereich der elektronischen Elemente hineinerstrecken können. Um das Ausbilden solcher Risse zu vermindern, werden komplizierte Verfahren angewandt, wie das Ausbilden von mehreren Nuten und das Aufbringen von zusätzlichen Schichten. Ein solches Verfahren ist aufwendig und teuer und kann das Entstehen von Rissen auch nicht vollständig ausschließen.

Bei der Herstellung elektronischer Elemente treten noch weitere Probleme auf. Üblicherweise wird ein Halbleiterwafer mit relativ großer Dicke benutzt, da der Halbleiterwafer dadurch wesentlich leichter bearbeitet werden kann. Andererseits bestehen an die elektronischen Elemente Anforderungen nach einer guten Wärmeabfuhr, einem geringeren elektrischen Widerstand und einer kleinen Bauhöhe, so daß sie eine möglichst geringe Dicke aufweisen sollen. Um diesen Anforderungen zu genügen, ist es daher üblich, einen relativ dicken Halbleiterwafer zu verwenden, der am Ende des Prozesses auf eine vorbestimmte Dicke abgedünnt wird. Da danach noch weitere

Bearbeitungsschritte, u.a. der Trennvorgang, ausgeführt werden müssen, darf eine bestimmte Dicke des Halbleiterwafers nicht unterschritten werden, damit eine ausreichende mechanische Stabilität und Belastbarkeit des Halbleiterwafers gewährleistet ist. Die Einsatzmöglichkeit der elektronischen Elemente wird aufgrund ihrer Dicke begrenzt. So kann beispielsweise bei einem Halbleiterwafer eines Durchmessers von 200 mm eine Dicke von 200 µm, welche der Dicke der elektronischen Elemente entspricht, nicht unterschritten werden. Beim Verwenden von Halbleiterwafern mit größeren Durchmessern können nur elektronische Elemente mit noch größerer Dicke hergestellt werden. Damit sind die mit den elektronischen Elementen erzielbaren Eigenschaften begrenzt. Vergleichbare Probleme treten auch beim Trennen von anderen in einem Körper verbundenen Elementen, insbesondere der oben genannten auf.

Der Erfindung liegt die Aufgabe zugrunde, ein verbessertes Verfahren zum Trennen von in einem Halbleiterwafer verbundenen elektronischen Elementen zu schaffen.

Diese Aufgabe wird durch ein Verfahren mit den Merkmalen des Patentanspruchs 1 gelöst.

Dadurch wird erreicht, daß bereits während des Trennvorgangs die Dicke des Körpers in dem Bereich der Verzögerungsschicht gleichzeitig reduziert werden kann. Das Trennen in die Elemente erfolgt dann durch Abtragen des Materials in den Trennbereichen des Körpers. Das Material der Verzögerungsschicht muß so gewählt sein, daß das Abtragen verlangsamt wird, so daß die Dicke des Körpers langsamer reduziert wird als der Trennvorgang der Elemente vor sich geht. Es wird somit vermieden, daß der Körper nach dem Abdünnvorgang als Ganzes weiterbearbeitet werden muß. Der Körper muß auch nicht als Ganzes von einer Vorrichtung zur anderen transportiert werden, da Abtragen und Trennen in einer Vorrichtung bei fester Position des Körpers durchgeführt werden. Somit kann eine geringere Dicke der Elemente erzielt werden. Die mechanische Stabilität der einzelnen Elemente ist dabei gewährleistet, da diese aufgrund ihrer kleineren Fläche eine entsprechend kleinere Dicke aufweisen können.

Zudem kann die Prozeßzeit verringert werden, da der Trennvorgang und der Abtragvorgang, die sonst nacheinander erfolgen würden, gleichzeitig durchgeführt werden. Der Trennvorgang kann vor dem Abtragvorgang begonnen werden, so daß dann beide Vorgänge gleich schnell erfolgen. Es kann aber auch der Trennvorgang schneller durchgeführt werden als der Abtragvorgang, so daß nach der Trennung Elemente mit einer vorgegebenen Dicke entstehen. Auch wird das Ausbilden von Rissen während des Trennvorgangs verringert, da das Material in den Trennbereichen abgetragen wird. Ein derartiges Abtragen von Material führt zu geringerer Rißbildung im Vergleich zu mechanischem Schneiden.

Gemäß der Erfindung erfolgt das Trennen der Elemente und das Abtragen des Stoffes des Körpers durch Ätzen, insbesondere durch Plasmaätzen. Hierdurch werden Rißbildungen besonders zuverlässig verhindert. Durch Plasmaätzen kann ferner eine besonders schnelle Durchführung des Verfahrens erreicht werden. Es ist günstig, wenn die Verzögerungsschicht eine niedrigere Ätzrate als das Material der Trennbereiche aufweist. Dann genügt eine dünne Verzögerungschicht, um den Abtragvorgang gegenüber dem Trennvorgang genügend zu verzögern.

Ferner ist es vorteilhaft, wenn innerhalb des abzudünnenden Bereichs wenigstens eine weitere Verzögerungsschicht mit Durchbrechungen in Tiefenbereichen ausgebildet ist. Ätzrate und Dicke sowie Anzahl der Verzögerungsschicht/en und Lage der Durchbrechungen der jeweiligen Verzögerungsschicht können so gewählt sein, daß die Elemente nach Beenden des Trennvorgangs eine vorbestimmte, ortsabhängige Dicke aufweisen. Somit lassen sich Dicke und Form der Elemente in vorherbestimmter Weise herstellen. Es können verschiedene Strukturen, Stufen, Schrägen, Rundungen u.ä. der Elemente auf der Seite des Körpers, auf der das Material abgetragen wird, ausgebildet werden.

Gemäß einem Ausführungsbeispiel der Erfindung wird eine Verzögerungsschicht aus dem Grundmaterial des Körpers ausgebildet. Die Dicke der Elemente nach dem Trennvorgang wird dann alleine durch die Dicke der Verzögerungsschicht bestimmt. Weitere Verzögerungsschichten können ebenfalls aus dem Grundmaterial des Körpers ausgebildet sein.

Gemäß einem weiteren Ausführungsbeispiel der Erfindung ist eine Verzögerungsschicht auf der Rückseite bzw. Vorderseite des Körpers aufgebracht und der Verzögerungsfaktor so gewählt, daß nach Beenden des Trennvorgangs ein wesentlicher Teil der ersten Verzögerungsschicht erhalten bleibt. Die Verzögerungsschicht kann aus Metall bestehen. In diesem Fall wird, insbesondere wenn das Trennen durch Ätzen erfolgt, nur ein sehr geringer Teil der Verzögerungsschicht abgetragen, so daß die Dicke der Elemente im wesentlichen der Dicke des Körpers entspricht, und im wesentlichen ein Trennvorgang vorliegt. Hierdurch wird ein schnelles, kostengünstiges Trennen der elektronischen Elemente gewährleistet, bei dem das Ausbilden von Rissen zuverlässig verhindert wird.

Gemäß der Erfindung ist der Körper ein Halbleiterwafer, und die Elemente sind elektronische Elemente. In diesem Beispiel läßt sich ein völlig neues Einsatzgebiet für elektronische Elemente erschließen, da diese aus Halbleiterwafern eines Durchmessers von 200 mm mit einer Dicke von 10 bis 20 um herstellbar sind. Beispielsweise würde dann die Wärmeabfuhr von hochintegrierten elektronischen Elementen wesentlich verbessert; bei elektronischen Hochleistungselementen wird die Verlustleistung reduziert, wodurch sich der Wirkungsgrad erhöht; aufgrund der geringen Bauhöhe wird eine breitere Verwendung elektronischer Elemente in Chipkarten möglich.

Im folgenden wird die Erfindung anhand der Zeichnung näher erläutert.

Es zeigen:
Fig. 1a bis 1c das erfindungsgemäße Verfahren zum Trennen von elektronischen Elementen auf einem Halbleiterwafer,
Fig. 2a bis 2c das erfindungsgemäße Verfahren zum Trennen von elektronischen Elementen einer SOI (Silicon On Isolator/Silizium auf Isolator)-Struktur und
Fig. 3 eine schematische Darstellung in Draufsicht auf einen Wafer mit voneinander zu trennenden elektronischen Elementen.

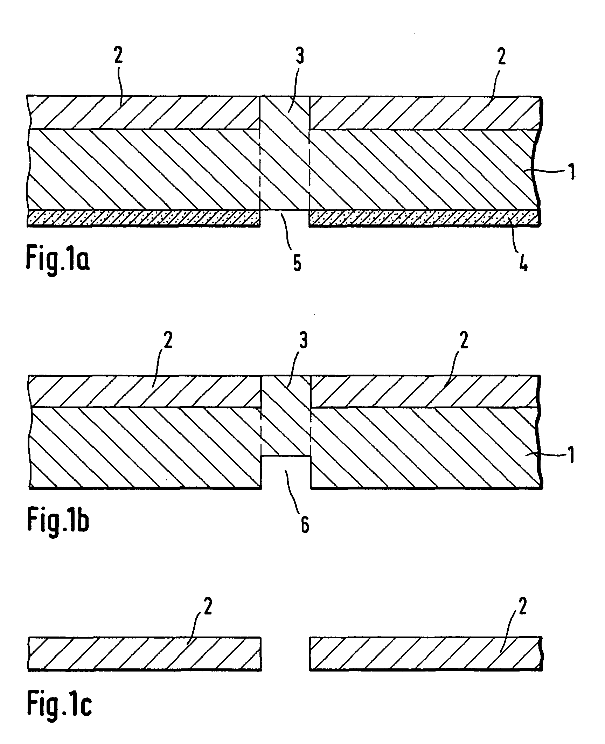

In Fig. 1 ist ein Halbleiterwafer 1 mit elektronischen Elementen 2 zu verschiedenen Zeitpunkten während der Durchführung des erfindungsgemäßen Verfahrens gezeigt. Fig. 1a zeigt einen Ausschnitt eines Halbleiterwafers 1 im Querschnitt zu einem ersten Zeitpunkt. In der Oberfläche des Halbeiterwafers 1 sind elektronische Elemente 2 ausgebildet. Zwischen diesen ist ein Trennbereich 3 vorgesehen, der auf dem Halbleiterwafer 1 zum Trennen der elektronischen Elemente 2 dient. Auf der Unterseite des Halbleiterwafers 1 ist eine Verzögerungsschicht 4 aufgebracht, die in dem Trennbereich 3 eine Durchbrechung 5 aufweist. Die Verzögerungsschicht 4 ist dabei so gewählt, daß sie eine niedrigere Ätzrate als das Grundmaterial des Halbleiterwafers 1 aufweist. Die gewünschte Enddicke der elektrischen Elemente 2 wird durch die Dicke der Verzögerungsschicht 4 und durch das Verhältnis der Ätzraten von dem Halbleiterwafer 1 und der Verzögerungsschicht 4 bestimmt. Die Dicke und das Material der Verzögerungsschicht 4 werden entsprechend gewählt. Der Halbleiterwafer 1 kann beispielsweise ein Siliziumwafer sein und die Verzögerungsschicht 4 eine Schicht aus einer Siliziumverbindung, deren Ätzrate niedrigerer ist als die des Siliziumwafers. Zur Bestimmung der gewünschten Dicke der elektronischen Elemente 2 und der aufzubringenden Verzögerungsschicht 4 ist ferner das Ätzmittel zu berücksichtigen, von welchem die Ätzrate der Verzögerungsschicht 4 und des Halbleiterwafers 1 abhängig ist.

In Fig. 1b ist der gleiche Ausschnitt des Halbleiterwafers 1 der Fig. 1a zu einem späteren Zeitpunkt dargestellt. Die Verzögerungsschicht 4 ist hier gerade vollständig weggeätzt. Da in dem vorliegenden Fall die Ätzrate der Verzögerungsschicht 4 halb so groß ist wie die Ätzrate des Halbleiterwafers 1, ist in dem Trennbereich 3 ein Teil 6 des Halbleiterwafermaterials 1 herausgeätzt, der doppelt so dick ist wie die Verzögerungsschicht 4. Im vorliegenden Beispiel entspricht die Dicke des Teils 6 der gewünschten Enddicke der elektronischen Elemente 2.

In Fig. 1c sind die voneinander getrennten elektronischen Elemente 2 nach Beenden des Trennvorgangs dargestellt. Das Material des Halbleiterwafers 1, das in der Fig. 1b noch vorhanden war, wurde vollständig weggeätzt. Da das Material des Halbleiterwafers 1 in diesem Bereich das gleiche ist wie das Material in dem gesamten Trennbereich 3, beispielsweise Silizium, erfolgte der Ätzvorgang in diesen Bereichen gleich schnell, so daß die in der Fig. 1b durch das herausgeätzte Teil 6 vorhandene Stufe in dem Trennbereich 3 erhalten blieb und während des Ätzvorgangs kontinuierlich verschoben wurde bis die elektronischen Elemente 2 der gewünschten Enddicke vollständig voneinander getrennt waren.

In den Figuren 1a bis 1c ist nur das prinzipielle Verfahren gemäß eines Ausführungsbeispiels gezeigt. Es sind weitere Varianten möglich; z. B. kann ein leichtes Überätzen über den Trennvorgang der elektronischen Elemente 2 hinaus durchgeführt werden.

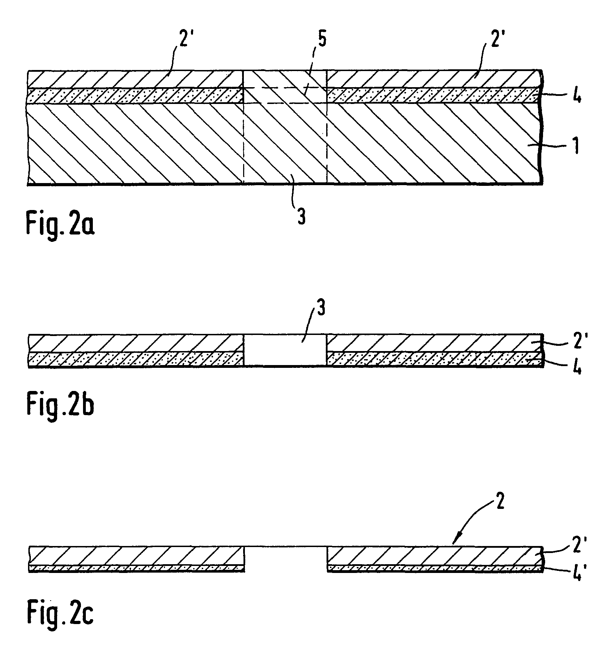

Fig. 2a zeigt einen Halbleiterwafer 1 mit einer SOI-Struktur. Die SOI-Struktur besteht aus der Verzögerungsschicht 4, die elektrisch isolierend ist, und einer darüberliegenden Schicht 2', in der sich die elektronischen Elemente 2 befinden. Die Verzögerungsschicht 4 weist in dem Trennbereich 3 zwischen den elektronischen Elementen 2 eine Durchbrechung 5 auf. Die Verzögerungsschicht 4 kann hier eine SiO₂-Schicht sein.

Fig. 2b zeigt den Halbleiterwafer 1, nachdem der Substratanteil des Siliziums bis zu der Verzögerungsschicht 4 weggeätzt ist. Bis zu diesem Punkt erfolgte das Wegätzen der Unterseite des Halbleiterwafers 1 mit der gleichen Geschwindigkeit. Die Verzögerungsschicht 4, hat hier eine Ätzrate, die deutlich niedriger ist als die Ätzrate des Siliziums. Beim Weiterätzen wird nun das Silizium in dem Trennbereich 3 schneller geätzt als die SiO₂-Schicht, d.h. die Verzögerungsschicht 4.

In Fig. 2c ist der Endzustand gezeigt, in dem die elektronischen Elemente 2 voneinander getrennt sind. Der Teil 4' der Verzögerungsschicht 4 ist hier Bestandteil der elektronischen Elemente 2. Das Ätzratenverhältnis des Materials in dem Trennbereich 3 zum Material der Verzögerungsschicht 4 beträgt in diesem Beispiel etwa 4:1.

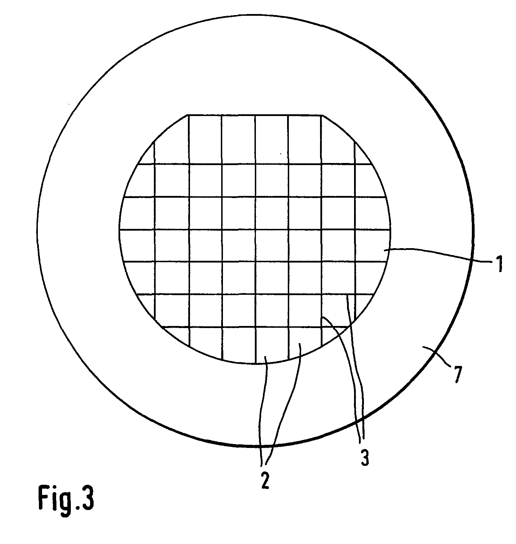

In Fig. 3 ist zur Veranschaulichung nochmals die schematische Darstellung gezeigt, bei der ein Halbleiterwafer 1 auf einer Folie 7 aufgeklebt ist. Die elektronischen Elemente 2 des Halbleiterwafers 1 sind durch Trennbereiche 3 voneinander getrennt. Ein wesentlicher Vorteil des erfindungsgemäßen Verfahrens ist bei allen Ausführungsbeispielen, daß bei dem gesamten Abtrag- und Trennvorgang der Halbleietrwafer 1 nicht transportiert werden muß, sondern das gesamte Verfahren in einer festen Position des Halbleiterwafers 1 durchgeführt werden kann.

Die in Fig. 1 und 2 dargestellen Verfahren sind lediglich zwei der möglichen Ausführungsbeispiele der Erfindung. Das erfindungsgemäße Verfahren kann ebenso auf andere Elemente und Körper angewendet werden. Es kann beispielsweise auch in dem Fall angewendet werden, in dem Wafer zu einem Verbundsubstrat zusammengefügt werden. An der Kontaktfläche der beiden zusammenzufügenden Wafer muß dann vorher eine entsprechende Verzögerungsschicht angebracht werden. Auch sind Anwendungen denkbar, bei denen das selektive Ätzen nicht auf der Rückseite des Halbleiterwafers sondern auf dessen Vorderseite erfolgt. Dies ist dann von Bedeutung, wenn Kontakte auf der Vorderseite des elektronischen Elements unerwünscht sind. In diesem Fall können Stufenstrukturen in der Oberfläche ausgebildet werden, in denen die Kontakte befestigt werden. Nicht zu ätzende Bereiche der Oberfläche müssen dann mit einer Ätzstoppschicht, vorzugsweise einer Metallschicht, bedeckt werden.

Auch ist das Verfahren beim Trennen von Verbundleiterplatten, von Keramikleiterplatten, von Sensorelementen, von Mikromaschinen etc. mit denselben Vorteilen anwendbar.

## Patentansprüche

1. Verfahren zum Trennen von elektronischen Elementen aus einem Halbleiterwafer, bei dem das Trennen durch Abtragen von Material in Trennbereichen (3) des Halbleiterwafers (1) durch Ätzen erfolgt, und die elektronischen Elemente (2), die auf der Vorderseite des Halbleiterwafers aufgebracht sind durch Abtragen von Material des Halbleiterwafers durch Atzen auf eine bestimmte Enddicke abgedünnt werden, **dadurch gekennzeichnet, daß** das Trennen und Abdünnen der elektronischen Elemente (2) von der Rückseite des Halbleiterwafers gleichzeitig erfolgt, wobei innerhalb eines abzudünnenden Bereiches des Halbleiterwafers (1) eine Verzögerungsschicht (4) zum Verzögern des Abdünnvorgangs vorgesehen ist, die in den Trennbereichen (3) jeweils eine komplette Durchbrechung (5) aufweist.

2. Verfahren nach Anspruch 1, **dadurch gekennzeichnet, daß** die Verzögerungsschicht (4) eine niedrigere Ätzrate als das Material des Halbleiterwafers der Trennbereiche (3) aufweist.

3. Verfahren nach einem der vorangehenden Ansprüche, **dadurch gekennzeichnet, daß** innerhalb des abzudünnenden Bereichs wenigstens eine weitere Verzögerungsschicht (4) in den Tiefenbereichen des Halbleiterwafers mit jeweils einer kompletten Durchbrechung (5) in den Trennbereichen (3) ausgebildet ist.

4. Verfahren nach Anspruch 3, **dadurch gekennzeichnet, daß** Ätzrate und Dicke sowie Anzahl der Verzögerungsschichtsen (4) so gewählt sind, daß die Elemente (2) nach Beenden des Trennvorgangs eine vorbestimmte, ortsabhängige Dicke aufweisen.

5. Verfahren nach einem der vorangehenden Ansprüche, **dadurch gekennzeichnet, daß** zumindest eine Verzögerungsschicht auf der Rückseite des Halbleiterwafers und aus einem Material des Halbleiterwafers (1) ausgebildet ist.

6. Verfahren nach einem der vorangehenden Ansprüche, **dadurch gekennzeichnet, daß** eine Verzögerungsschicht (4) auf der Rückseite bzw. Vorderseite des Halbleiterwafers (1) aufgebracht ist.

7. Verfahren nach Anspruch 3, **dadurch gekennzeichnet, daß** das Abdünnen derart verzögert wird, daß nach Beenden des Trennvorgangs ein Teil einer Verzögerungsschicht (4) in den Tiefenbereichen des Halbleiterwafers erhalten bleibt.

8. Verfahren nach Anspruch 6 oder 7, **dadurch gekennzeichnet, daß** eine Verzögerungsschicht (4) aus Metall besteht.

## Claims

1. A method of separating electronic elements from a semiconductor wafer wherein the separation is accomplished by removing material in separation regions (3) of the semiconductor wafer (1) by etching, and wherein the electronic elements (2) which were formed on the front side of the semiconductor wafer, are thinned to a specified final thickness by removing material of the semiconductor wafer by etching, **characterized in that** the separation and thinning of the electronic elements (2) is done simultaneously from the backside of the semiconductor wafer, with an area of the semiconductor wafer (1) to be thinned being provided with a delay layer (4) for delaying the material-removing process which has a through opening (5) in each of the separation regions (3).

2. A method as set forth in claim 1, **characterized in that** the delay layer (4) has a lower etch rate than the material of the semiconductor wafer in the the separation regions (3).

3. A method as set forth in any one of the preceding claims, **characterized in that** in the region to be thinned, at least one further delay layer (4) having a through opening (5) in each of the separation regions (3) is formed in the depth regions of the semiconductor wafer.

4. A method as set forth in claim 3, **characterized in that** the etch rate, thickness, and number of the delay layer/layers (4) are so chosen that after completion of the separating process, the elements (2) have a predetermined, locus-dependent thickness.

5. A method as set forth in any one of the preceding claims, **characterized in that** at least one delay layer is formed on the backside of the semiconductor wafer (1) and is made of a material of the semiconductor wafer (1).

6. A method as set forth in any one of the preceding claims, **characterized in that** a delay layer (4) is deposited on the backside or the front side of the semiconductor wafer (1).

7. A method as set forth in claim 3, **characterized in that** the thinning is delayed so that after completion of the separating process, a portion of a delay layer (4) is preserved in the depth regions of the semiconductor wafer.

8. A method as set forth in claim 6 or 7, **characterized in that** a delay layer (4) is made of metal.

## Revendications

1. Procédé pour séparer des éléments électroniques d'une plaquette de semi-conducteur, dans lequel la séparation est réalisée par enlèvement de matière dans les zones de séparation (3) de la plaquette de semi-conducteur (1) par attaque chimique et les éléments électroniques (2), qui sont déposés sur la face avant de la plaquette de semi-conducteur (1), sont amincis jusqu'à une épaisseur finale déterminée par enlèvement de matière de la plaquette de semi-conducteur par attaque chimique, **caractérisé en ce que** les opérations de séparation et d'amincissement des éléments électroniques (2) sont réalisées en même temps à partir de la face arrière de la plaquette de semi-conducteur (1), procédé dans lequel, à l'intérieur d'une zone à amincir de la plaquette de semi-conducteur (1), on prévoit une couche de retardement (4) qui est destinée à retarder le processus d'amincissement et qui comporte, dans les zones de séparation (3), à chaque fois, une découpe complète (5).

2. Procédé selon la revendication 1, **caractérisé en ce que** la couche de retardement (4) présente un taux d'attaque chimique plus faible que celui de la matière des zones de séparation (3) de la plaquette de semi-conducteur (1).

3. Procédé selon l'une quelconque des revendications précédentes, **caractérisé en ce que**, à l'intérieur de la zone à amincir, on forme au moins une autre couche de retardement (4) dans les zones profondes du la plaquette de semi-conducteur (1) avec, à chaque fois, au moins une découpe complète (5) dans les zones de séparation (3).

4. Procédé selon la revendication 3, **caractérisé en ce que** l'on choisit les taux d'attaque chimique et les épaisseurs ainsi que le nombre des couches de retardement (4) de telle manière que les éléments (2) présentent, après la fin du processus de séparation, une épaisseur prédéterminée dépendant de l'emplacement.

5. Procédé selon l'une quelconque des revendications précédentes, **caractérisé en ce que** l'on forme une couche de retardement sur la face arrière de la plaquette de semi-conducteur (1) et en une matière de la plaquette de semi-conducteur (1).

6. Procédé selon l'une quelconque des revendications précédentes, **caractérisé en ce que** l'on dépose une couche de retardement (4) sur la face arrière ou la face avant de la plaquette de semi-conducteur (1).

7. Procédé selon la revendication 3, **caractérisé en ce que** le processus d'amincissement est retardé de telle manière que, après la fin du processus d'attaque chimique, il reste une partie de la couche de retardement (4) dans les zones profondes de la plaquette de semi-conducteur (1).

8. selon la revendication 6 ou 7, **caractérisé en ce qu'**une couche de retardement (4) est en métal.
